# EUROPEAN PATENT APPLICATION

(11) **EP 1 279 933 A1**
(43) Date of publication of application: **29.01.2003**
(21) Application number: 01272807.7
(22) Date of filing: 11.12.2001
(51) Int. Cl.: G01D 11/02, G01R 5/16, F16C 33/10

(54) **MOVABLE MAGNET TYPE MEASURING INSTRUMENT**

(30) Priority: 28.12.2000 JP 2000399701
(71) Applicant: NIPPON SEIKI CO., LTD., Nagaoka-shi, Niigata 940-8580 (JP)
(72) Inventor: SATOH, Hitoshi c/o Nippon Seiki Co., Ltd., Nagaoka-shi Niigata 940-8580 (JP)
(74) Representative: Jackson, Richard Eric
(86) International application number: JP0110867
(87) International publication number: WO02054016

(57) **Abstract**

To provide a moving magnet type metering device that is cheap and can make an influence affecting on operation characteristics of an indicator smaller, and furthermore can suppress damper oil from leaking. The moving magnet type metering device includes a magnet rotor 2 having a turning shaft 1, a frame body 4 that has a cavity portion 3 for accommodating the magnet rotor 2 and supports the turning shaft 1, coils 5 and 6 that are disposed along an outer periphery of the frame body 4 and drive the magnet rotor 2, and damper oil D that is filled in the cavity portion 3. In the above, a rough surface portion S that suppresses the damper oil D from moving is disposed on at least one of an external surface 21 of the magnet rotor 2 or an internal surface 31 of the cavity portion 3.

## Description

### Technical Field

The present invention relates to a moving magnet type metering device for driving an indicator of, for instance, an indicator type metering device for use in an automobile.

### Background Art

So far, as moving magnet type metering device of this kind, a lot of cross coil moving magnet type metering devices in which a permanent magnet rotor is rotated corresponding to an amount of an electric current that flows the cross coil are used. The moving magnet type metering device is constituted in such a way that a magnet rotor having a turning shaft at a center portion thereof is accommodated in a frame body (bobbin case) made of a resin material and pivotally supported therein, and a pair of cross coils are wound around an outer periphery of the frame body. Damper oil is filled in the frame body. The damper oil endows the magnet rotor with a braking force, and thereby a braking effect is given to an indicator that is connected to the turning shaft and turns pivotally around the shaft.

Thus configured moving magnet type metering device, in the course of, for instance, assembly, may be temporarily inclined or put upside down. Thereby, the damper oil moves toward a turning shaft pulling out side in the frame body and may leak outside from a gap between the turning shaft and the frame body. As one that takes this point into consideration, there is one such as disclosed in, for instance, Japanese Patent Laid-Open No. 87833/1993 in which, on an inner bottom surface of a frame body, an annular damper oil movement inhibiting film is disposed, and thereby the damper oil is inhibited from leaking. Furthermore, there is another one such as disclosed in Japanese Utility Model Laid-Open No. 109172/1991 in which irregularities are formed on an internal surface of a frame body and an external surface of a magnet rotor, and thereby the damper oil is inhibited from leaking.

However, as in the former case, in disposing, on the internal surface of the frame body, the annular damper oil movement inhibiting film, since a highly specific film is necessary to be formed, there is a problem in that its cost becomes higher. Furthermore, when the irregularities are formed like in the latter case, since a larger influence is applied on the operation characteristics of the indicator, in the worst case the operation characteristics may be damaged.

The present invention is conducted in view of these points and intends to provide a moving magnet type metering device that is cheap and less in an influence affecting on the operation characteristics of the indicator, and in addition to these, can inhibit the damper oil from leaking.

### Disclosure of the Invention

A moving magnet type metering device of the present invention includes a magnet rotor having a turning shaft, a frame body that has a cavity for accommodating the magnet rotor and supports the turning shaft, coils that are disposed along an outer periphery of the frame body and drive the magnet rotor, and damper oil that is filled in the cavity. In the above, a rough surface portion that inhibits movement of the damper oil is disposed on at least one of an external surface of the magnet rotor or an internal surface of the cavity, thereby without forming a highly specific film as in the existing case, a cheaper configuration allows suppressing the damper oil from leaking, resulting in an increase of product reliability.

Furthermore, when the rough surface portion is formed on a bottom side internal surface of the cavity portion, in addition to the suppression of leakage of the damper oil, the frame body can be easily formed.

### Brief Description of the Drawings

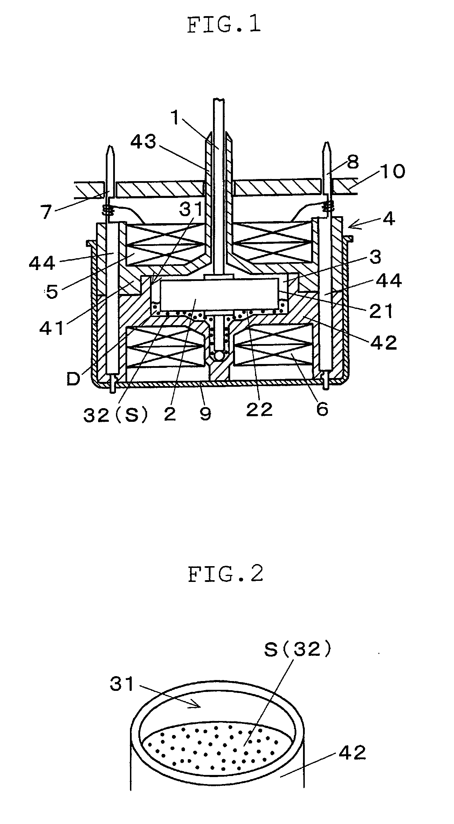

Fig. 1 is a sectional view showing a state after a moving magnet type metering device according to an embodiment of the present invention is assembled, and Fig. 2 is a perspective view showing an essential portion of a lower side half body that partially constitutes the frame body in the same embodiment.

### Best Modes for Carrying Out the Invention

In the following, an embodiment of the present invention will be explained with reference to Figs. 1 and 2. In Fig. 1, the moving magnet type metering device includes a turning shaft 1; a magnet rotor 2 that is penetrated by and fixed to the turning shaft 1; a frame body 4 that is provided with a cavity 3 that accommodates the magnet rotor 2 and pivotally supports the turning shaft 1; a pair of cross coils 5 and 6 that are wound orthogonal to each other along an outer periphery of the frame body 4; a plurality of terminals 7 and 8 that extend in parallel with the turning shaft 1, is held by the frame body 4 and is electrically conductively connected to each of the coils 5 and 6; and a cylindrical cup shield case 9 in which tip end side of the turning shaft 1 and the terminals 7 and 8 are opened and the frame body 4 is accommodated. In the above, a main portion excluding the turning shaft 1 is located behind a circuit board 10 that is an external electric member, and the turning shaft 1 is mounted on the circuit board 10 so as to penetrate through the circuit board 10 and extend forward.

The magnet rotor 2 is made of a disc-like plastic magnet in which N pole and S pole are bipolar magnetized in a radial direction with respect to the turning shaft 1 at a center, and the turning shaft 1 is penetratingly fixed to a center of the magnet rotor.

The frame body 4 is made of a so-called coil bobbin in which an upper half body 41 and a lower half body 42, each of which being made of a synthetic resin, are combined together, and thereby a cavity portion 3 for accommodating the magnet rotor 2 inside thereof is formed; and includes a cylindrical tubular portion 43 that penetrates through the circuit board 10 together with the turning shaft 1 and constitutes an upper roller bearing portion of the turning shaft 1; and a hole-like terminal accommodating portions 44 that accommodate and hold the terminals 7 and 8 disposed at columnar positions that become winding guides of the coils 5 and 6.

In an internal surface 31 of the cavity portion 3 that faces an external surface 21 of the magnet rotor 2, on a bottom side internal surface 32 (a corresponding surface of the lower half body 42) of the cavity portion 3 that faces a bottom side external surface 22 of the magnet rotor 2, as shown in Fig. 2, is formed a rough surface portion S whose surface roughness is set at irregularities of, for instance, about 50 µm. The rough surface portion S is formed in injection-molding the respective half bodies 41 and 42 with synthetic resin. At this time, in molding the lower half body 42, on a surface of a molding die corresponding to a position where the rough surface portion S is formed, fine irregularities are formed by scraping by means of discharge machining, or by eroding by means of etching.

In the cavity portion 3 thus formed, damper oil D is filled, and in the state shown in Fig. 1, the damper oil D is located in a bottom side region of the cavity portion 3 including the bottom side external surface 22 of the magnet rotor 2 and the bottom side internal surface 32 of the cavity 3. The damper oil D intervening between the external surface 21 of the magnet rotor 2 and the internal surface 31 of the cavity 3 applies a braking force on the magnet rotor 2, thereby endowing a braking effect to a not shown indicator that is connected to the turning shaft 1 and turns around the shaft according to a measured amount.

In the state shown in Fig. 1, the damper oil D, as mentioned above, is located in the bottom side of the cavity portion 3 including the bottom side external surface 22 of the magnet rotor 2 and the bottom side internal surface 32 of the cavity 3 that faces the bottom side external surface 22 of the magnet rotor 2. However, in the course of, for instance, assembly, it may be temporarily inclined or put upside down. At this time, the damper oil D moves toward the tubular portion 43 side that is a pulling-out side of the turning shaft 1 of the frame body 4 and may leak outside from the gap between the turning shaft 1 ant the tubular portion 43. However, according to the present embodiment, since the cavity portion 3 is provided with the rough surface portion S that can suppress the damper oil D from moving, the rough surface portion S makes the damper oil D difficult to flow, resulting in suppressing the leakage thereof.

As mentioned above, in the present embodiment, the rough surface portion S is formed on the bottom side internal surface 32 of the cavity portion 3 that faces the bottom side external surface 22 of the magnet rotor 2. Thereby, without forming a particular film as in the existing case, a cheap structure allows suppressing the damper oil D from leaking, resulting in improving product reliability.

Furthermore, in the present embodiment, since without forming the large irregularities between the external surface of the magnet rotor and the internal surface of the cavity portion as in the existing case, the damper oil D can be suppressed from moving, an influence affecting on the operation characteristics of the indicator can be made smaller.

Still furthermore, in the present embodiment, as shown in Fig. 2, since the rough surface portion S is formed, not on the side surface portion (the internal surface 31) of the cavity 3, but on the bottom side internal surface 32 thereof, the lower half body 42 can be easily formed.

Furthermore, in the present embodiment, although the rough surface portion S is disposed on the bottom side internal surface 32 of the cavity portion 3, it may be disposed on the bottom side external surface 22 of the magnet rotor 2 or on both of the bottom side external surface 22 and the bottom side internal surface 32. In addition, it may be disposed also on other positions than those where the damper oil D is likely to remain. Furthermore, it can be arbitrarily formed on a position that is on at least one of the external surface 21 of the magnet rotor 2 or the internal surface 31 of the cavity portion 3 and can suppress the leakage when the damper oil D moves. The surface roughness of the rough surface portion S may be set fine to an extent that does not largely damage the operation characteristics of the indicator.

The present embodiment examplifies that the coils 5 and 6 are directly wound around the outer periphery of the frame body 4, however, a coil holder for exclusively holding the coils 5 and 6 may be separately disposed, and the coil holder may be attached to the frame body 4. The coils 5 and 6 may be disposed, not in cross, but in a state where they face the magnet rotor 2.

The position where the rough surface portion S is formed is not restricted to those in the embodiment. So long as the damper oil D can be suppressed from leaking from the gap between the turning shaft 1 and the tubular portion 43, the rough surface portion S can be disposed on an arbitrary position of the external surface 21 of the magnet rotor 2 or the internal surface 31 of the cavity 3.

### Industrial Applicability

The present invention is applicable to a moving magnet type metering device that drives an indicator of a metering device for use in a vehicle that is mounted on various kinds of vehicles including automobiles and autobicycles.

## Claims

1. A moving magnet type metering device, **characterized in** comprising:
a magnet rotor having a turning shaft;
a frame body that has a cavity portion for accommodating the magnet rotor and supports the turning shaft;
coils that are disposed along an outer periphery of the frame body and drive the magnet rotor; and
damper oil that is filled in the cavity portion;
wherein a rough surface portion that suppresses the damper oil from moving is disposed on at least one of an external surface of the magnet rotor or an internal surface of the cavity portion.

2. A moving magnet type metering device as set forth in claim 1, **characterized in that** the rough surface portion is formed on a bottom side external surface of the magnet rotor or a bottom side internal surface of the cavity portion.
